# EUROPEAN PATENT SPECIFICATION

(11) **EP 0 348 496 B1**
(45) Date of publication and mention of the grant of the patent: **05.10.1994**
(21) Application number: 89901981.4
(22) Date of filing: 16.12.1988
(51) Int. Cl.: B05D 5/12, C23C 8/06

(54) **CHEMICAL VAPOR DEPOSITION OF MIXED OXIDE FILMS**
CHEMISCHER DAMPF-NIEDERSCHLAG VON GEMISCHTEN OXIDFILMEN
DEPOSITION DE PELLICULES DE SYSTEMES D'OXYDES MIXTES EN PHASE GAZEUSE PAR PROCEDE CHIMIQUE

(30) Priority: 17.12.1987 US 134251
(43) Date of publication of application: 03.01.1990
(73) Proprietor: UNIVERSITY OF COLORADO FOUNDATION, INC., Boulder, CO 80306 (US)
(72) Inventor: SIEVERS, Robert, E., Boulder, CO 80302 (US)
(74) Representative: DIEHL GLAESER HILTL & PARTNER
(86) International application number: US8804519
(87) International publication number: WO8905696

(56) References cited:
- EP-A- 0 319 585
- WO-A-89/03594
- DE-A- 3 827 069
- APPLIED PHYSICS LETTERS, vol. 52, no. 20, 16th May 1988, pages 1743-1745, New York, US; A.D. BERRY et al.: "Formation of high Tc superconducting films by organometallic chemical vapor deposition"
- JAPANESE JOURNAL OF APPLIED PHYSICS/PART 2: LETTERS, vol. 27, no. 9, September 1988, pages L1683-L1685, Tokyo, JP; K. SHINOHARA et al.: "Preparation of Y-Ba-Cu-O superconducting thin film by chemical vapor deposition"
- JOURNAL OF CRYSTAL GROWTH, vol. 92, nos. 1-2, 1st October 1988, pages 344-347, Elsevier Science Publishers B.V., Amsterdam, NL; A.D. BERRY et al.: "Growth of superconducting thin films of bismuth-strontium-calcium-copper oxide by organometallic chemical vapor deposition"

## Description

The present invention relates to a method for forming a film comprising a mixture of rare earth, alkaline earth and copper oxides on a substrate and a film obtainable by that method.

Metal organic chemical vapor deposition is one of several techniques that may be used for the formation of thin films of materials on suitable substrates. For example, metal organic chemical vapor deposition has been used in semiconductor processing and is most useful when the reagents or starting materials are volatile compounds which react at substrate surfaces to form films thereon. Metallo-organic compounds such as trimethylaluminum, trimethylgallium, triethylindium and the like have been used in these processes.

From EP-A-0 319 585, a document to be considered under Art. 54(3) EPC, a process for preparing a superconducting thin oxide film is known. The process comprises the steps of mixing a gas of at least one organo-metal compound of a group IIIa element and/or a halogenide thereof, and a gas of at least one organometal compound of a transition metal and/or a halogenide thereof, with an inert gas to form a gas mixture, mixing an oxygen containing gas to said gas mixture to produce a gas mixture having a predetermined oxygen partial pressure, and thermally decomposing said gas mixture having the predetermined oxygen partial pressure on a substrate to produce a thin film of a complex oxide on said substrate.

Various metallo-organic complexes or chelates have also been employed in the gas chromatographic study of metal coordination compounds. For example, Sievers et al. disclose in "Volatile Rare Earth Chelates of β-Diketones", Advances in Chemistry Series, No. 71, pages 141-154 (1967), the synthesis and study of volatile rare earth chelates of β-diketones. Volatile rare earth chelates are also disclosed by Eisentraut et al., Journal of the American Chemical Society, 87:22, pages 5254-5256 (1965), and Inorganic Syntheses, pages 94-98 (1968). The separation and purification of rare earth chelates is also disclosed in the Eisentraut et al. U.S. Patent No. 3,429,904. The Eisentraut et al. U.S. Patent No. 3,794,473 and the Sievers et al. U.S. Patent No. 4,251,233 further disclose the use of rare earth chelates in liquid hydrocarbon fuels such as gasoline and diesel oil.

Other metallo-organic complexes or chelates are also known in the art. For example, Schwarberg et al., Analytical Chemistry, Vol. 42, pages 1828-1830 (1970), disclose the preparation of alkaline earth chelates with β-diketones and the gas chromatographic separation and analysis of such compounds. The preparation of other metallo-organic chelates or complexes, including copper metal chelates, is disclosed by Wenzel et al., Polyhedron, Vol. 4, No. 3, pages 369-378 (1985).

The chemical vapor deposition of metallo-organic chelates or complexes in the formation of single crystal garnet films is disclosed by Cowher et al., Journal of Crystal Growth, No. 46, pages 399-402 (1979) and Journal of Electronic Materials, Vol. 3, No. 3, pages 621-633 (1974). The growth of single crystal films of lithium niobate using chemical vapor deposition of lithium-organic complexes is disclosed by Curtis et al., Materials Research Bulletin, Vol. 10, pages 515-520 (1975). The chemical vapor deposition of metal films from metal-organic complexes or chelates is also known in the art as evidenced by van Hemert et al., Journal of the Electrochemical Society, Vol. 112, No. 11, pages 1123-1126 (1965) and the Moshier et al. U.S. Patent No. 3,356,527.

Recently, superconductive compositions including mixed oxides of rare earth, alkaline earth and copper metals have been discovered. For example, Wu et al., Physical Review Letters, Vol. 58, No. 9, pages 908-910 (1987) and Hor et al., Physical Review Letters, Vol. 58, No. 9, pages 911-912 (1987), disclose Y-Ba-Cu-O compound systems as exhibiting superconductivity. Additionally, in Physical Review Letters, Vol. 58, No. 18 (1987), Moodenbaugh et al. (pages 1885-1887), Murphy et al. (pages 1889-1890) and Hor et al. (pages 1891-1894) disclose additional rare earth, alkaline earth, copper metal mixed oxide compositions exhibiting superconductive properties. Additional rare earth, alkaline earth, copper metal mixed oxides are disclosed by Er-Rakho et al., Journal of Solid State Chemistry, Vol. 37, pages 151-156 (1981). Generally, these references disclose the formation of the rare earth, alkaline earth, copper metal mixed oxide compositions by sintering the individual oxide powders. The resulting ceramic superconducting materials have been relatively brittle and therefore their use in various applications has been significantly limited.

It is therefore the object of the present invention to provide a method for forming a film on a substrate, which method employs simple processing and handling steps and which provides a film having improved ductility.

This object is solved by the method according to independent claim 1 as well as the film according to independent claim 13.

Particular embodiments of the invention are disclosed in the dependent claims.

Further advantageous features, aspects and details of the invention are evident from the description and the examples.

The method is particularly useful for forming catalyst films and/or films which may function as superconductors of electricity at temperatures as high as 90 K.

This and additional aspects are provided by the method according to the present invention. Briefly, the present invention relates to a method for forming a film comprising a mixture of rare earth, alkaline earth and copper oxides on a substrate. The method of the invention comprises the step of forming a metallo-organic complex of each of a rare earth metal, an alkaline earth metal and copper. Each of the metallo-organic complexes has a vaporization temperature below the temperature at which the metallo-organic complexes rapidly thermally decompose, oxidize or hydrolyze. In a further step, a vaporized mixture of the metallo-organic complexes is formed and the vapors are contacted with a substrate on which a film is to be deposited. Deposition of the film is then induced from the vapors onto the substrate. In a last step, deposition of the vapors onto the substrate to form the film is achieved by a technique selected from oxidizing the vapors, hydrolyzing the vapors at a temperature higher than the vaporization temperatures of the metallo-organic complexes, irradiating the vapors with radiant energy, and passing the vapors through plasma.

The mixed oxide films which may be prepared according to the method of the present invention generally exhibit improved ductility and are useful in various applications. For example, the films are suitable for use as catalysts in redox chemiluminescence detectors, as electrical superconductors, and in a variety of additional devices as will be set forth hereinafter. The compositions of the resultant films may be varied by changing the ratios of the metallo-organic complexes which are mixed prior to vaporization, as well as by oxidizing the materials.

These and additional aspects and advantages of the invention will become more apparent and fully understood in view of the following detailed description.

According to the method of the present invention, films comprising a mixture of rare earth, alkaline earth and copper oxides are deposited on a substrate by inducing deposition from a vapor mixture of metallo-organic complexes. A metallo-organic complex or chelate is formed with each of a rare earth metal, an alkaline earth metal and a copper metal. The organic ligands which are used to form the complex or chelate may comprise any organic compounds known in the art for the formation of such complexes as long as the resultant metallo-organic complexes exhibit vaporization temperatures below the temperatures at which any of the metallo-organic complexes which are to be mixed rapidly thermally decompose, oxidize or hydrolyze. Particularly suitable organic compounds for use in forming the metallo-organic complexes for use in the invention are protonated ligands including β-diketones including, but not limited to, 2,2,6,6-tetramethyl-3,5-heptanedione, H(thd), and 2,2,7-trimethyl-3,5-octanedione, H(tod). Additionally, the metal complexes or chelates may be formed using fluorinated ligands such as trifluoroacetylcamphor; 1,1,1-trifluoro-2,4-pentanedione, H(tfa); 1,1,1,5,5,5-hexafluoro-2,4-pentanedione, H(hfa); or 1,1,1,2,2,3,3-heptafluoro-7,7-dimethyl-4,6-octanedione, H(fod), also known as 2,2-dimethyl-6,6,7,7,8,8,8-heptafluoro-3,5-octanedione, whereby the resultant oxide composition can also include a fluoride component. Auxiliary complexing agents that can form more coordinatively saturated metal chelates can be added to the metal complexes to make them more volatile. Examples are di-n-butylsulfoxide or excess protonated β-diketones such as H(tod), H(thd), H(fod) or H(tfa).

Any rare earth metal may be used in the method of the present invention. Generally, rare earth metals are defined as the group of metals including the lanthanide elements, scandium and yttrium. Preferred rare earth metals for use in the method of the present invention include yttrium, europium, gadolinium, neodymium, samarium, holmium, erbium and ytterbium. Similarly, any of the alkaline earth metals may be used in the method of the present invention with barium and strontium being preferred alkaline earth metals. In a particularly preferred embodiment of the invention, the rare earth metal comprises yttrium and the alkaline earth metal comprises barium. In this embodiment, the ratio of metallo-organic complexes which are vaporized may be controlled in order to provide a deposited film of the formula YBa₂Cu₃Oₓ where x is in the range of about 6.5 to about 7.0. Generally, the stoichiometric ratio of metal complexes in the vapor mixture is preferably about 1 rare earth:2 alkaline earth:3 copper, although other ratios may be used in the method according to the invention.

As set forth above, each of the metallo-organic complexes or chelates has a vaporization temperature below the temperatures at which any of the metallo-organic complexes rapidly thermally decompose, oxidize or hydrolyze. This allows the formation of a vaporized mixture of the metallo-organic complexes which is initially stable. The vaporized mixture is contacted with a substrate on which the desired film is to be deposited. The substrate on which the film is deposited may be formed of any suitable material including, but not limited to, glass, metal or ceramic materials. Additionally, the substrate may be in a variety of forms such as, for example, in the form of a wire or tubing which is to be coated with the deposited film. Thus, the method according to the present invention may be used to coat a layer of a superconducting mixed oxide composition on a copper wire or tubing or a flexible fused silica capillary tubing.

Copper surfaces such as copper wire or capillary tubing, or thin sheets of copper metal are particularly suitable substrates for use in the method of the present invention because copper itself is a ductile material and is commonly used in various applications, for example, magnets, motors and other current-carrying devices.

Fused silica substrates are also particularly suitable for use in the method of the present invention to allow fabrication of flexible conduits of superconductors from lightweight-easily manipulatable tubes and fibers of the fused silica. Currently, fused silica is used for such diverse applications as fiber optic cables for the transmission of light and communications and as a material for the construction of coated chromatographic columns. When capillary columns of fused silica are coated with aluminum or a polymer for protection, these columns are sufficiently flexible that they can be bent and even tied in loose knots. The method of the present invention may be used to provide thin films of superconductor metal oxides coated on the inner walls of the silica capillary columns for use in lightweight motors, magnets and the like.

According to the method of the present invention, a film comprising a mixture of rare earth, alkaline earth and copper oxides is then deposited from the vapors onto the substrate. Deposition of the mixed oxide film may be induced by a variety of means. For example, the substrate on which the film is to be deposited may be heated to a temperature which is sufficiently high to cause thermal decomposition of the vapors. When β-diketones are used to form the metal complexes or chelates, the mixture of complexes may be vaporized at a temperature in the range of from about 150^{o}C to about 200^{o}C, and thermal decomposition may be effected by heating the substrate surface to a temperature in the range of approximately 400 to 1000^{o}C. Alternatively, the film deposition may be induced by oxidation of the vapors using an oxidizing agent such as oxygen. A mixture of oxygen and fluorine may also be used as an oxidizing agent whereby the resultant film includes a fluorine component. It is also possible to induce deposition of the mixed oxide film by a combination of these means whereby excess oxygen may be included in the vaporized mixture while simultaneously the substrate is heated to a temperature within the aforementioned range.

In an additional embodiment of the method of the present invention, deposition of the mixed oxide film may be induced by hydrolysis of the vapors at a temperature higher than the vaporization temperatures of the metallo-organic complexes. Hydrolysis causes removal of the organic ligand and simultaneous insertion of oxygen bridges in the resultant composition. Alternatively, the deposition of the mixed oxide film may be induced by irradiating the vaporized mixture with radiant energy or by passing the vaporized mixture through a plasma.

The composition and/or crystallinity of the mixed oxide film which is formed may be varied by varying the concentrations of the metallo-organic complexes in the vaporized mixture, the temperature at which the vaporized mixture is contacted with the substrate, the temperature of the substrate, and/or the amount of oxygen or water which is present at the substrate surface.

The method according to the present invention may also include further treatment of the mixed oxide film which is deposited on the substrate. For example, it has recently been reported that the degree of oxygen sufficiency/deficiency in perovskite cuprates affects the degree to which the compositions exhibit superconductivity, particularly in the family of compounds of the formula RBa₂Cu₃O₇₋ₓ where R is a rare earth metal and x is a number less than 1. Thus, a preferred embodiment of the method according to the present invention includes the additional step in which the deposited film is further oxidized by treating the film with an oxidizing agent to form a mixed metal oxide composition of the formula RBa₂Cu₃O_{7-y} where y is less than x. Nitrogen dioxide has been demonstrated to be a very good source of active oxygen atoms and therefore is suitable for use as an oxidizing agent for further oxidizing the film composition. More specifically, a powdered pellet of YBa₂Cu₃O₇₋ₓ which was rendered oxygen deficient by heating was rapidly quenched and treated with NO₂, resulting in copious formation of NO, even at room temperature, over several minutes. Ozone and other strong oxidizing agents may also be used in this regard. The Sievers Research, Inc. Model 207 Redox Chemiluminescence Detector apparatus includes a chamber for production of ozone by electrical discharge and a permeation tube emitting NO₂ which can be conveniently used as sources of ozone and nitrogen dioxide in this process.

Compositions of mixed rare earth, alkaline earth and copper oxides which include a fluorine component have also been demonstrated as exhibiting superconductive properties. Accordingly, the method according to the present invention may include a further step wherein the deposited film is treated with elemental fluorine, whereby fluorine atoms are introduced into the mixed oxide composition. For example, the deposited film may be treated with elemental fluorine by passing SF₆ through an electrical discharge and contacting the reactive effluent from the discharge with the deposited film. Elemental fluorine may conveniently be generated in situ using a Sievers Research, Inc. Model 300 Sulfur-Selective Chromatography Detector apparatus by reducing the pressure of the electrical discharge chamber to about 10.6 mbar (about 8 Torr) while passing SF₆ through the apparatus.

The method according to the present invention may be used to provide various ductile superconducting materials for use in products including electrical machinery, power transmission lines, magnets, sensors, and magnetic resonance imaging equipment, to recite just a few of the many applications. The relatively easy method according to the present invention for fabricating the mixed oxide films which exhibit superconductivity will further expand the number of applications in which these compositions may be used.

It has additionally been discovered that films comprising a mixture of rare earth, alkaline earth and copper oxides, for example, such as those prepared according to the present invention, may be used as catalysts in redox chemiluminescence detectors to provide improved detection properties. Redox chemiluminescence detectors are generally disclosed by Sievers et al., Journal of Chromatography, Vol. 349, pages 395-403 (1985), Hutte et al., Journal of Chromatographic Science, Vol. 24, pages 499-505 (1986), and Nyarady et al., Analytical Chemistry, Vol. 57, pages 2074+ (1985).

Generally, redox chemiluminescence detectors are insensitive to the major constituents of ambient air and are sensitive to many toxic potential contaminants of confined environments. Redox chemiluminescence detectors include a catalyst which accelerates reactions of traces of nitrogen dioxide or another reagent such as dilute nitric acid with toxic contaminants such as carbon monoxide, monomethylhydrazine, benzene, methanol, acetonitrile, formaldehyde and other aldehydes, ketones, alcohols, sulfides and hydrocarbons. The character of the catalyst included in the detector determines which contaminants will be sensed in the reaction sequence upon which the detector is based. The resultant chemiluminescent radiation which is measured is proportional to the activity of the catalyst. While gold has been the most frequently used catalyst, it has now been discovered that a mixture of rare earth, alkaline earth and copper oxides, particularly a mixture of yttrium, barium and copper oxides, provides a more active catalyst than the conventional gold catalyst and allows detection of a larger number of compounds which need to be monitored continuously or nearly continuously. Using these compositions, benzene, acetonitrile and methanol can be detected by the nitric oxide that they form from nitrogen dioxide at lower temperatures than are possible using the conventional gold catalysts. Ubiquitous saturated hydrocarbons by contrast do not rapidly react with nitrogen dioxide at ambient temperature. Specifically, the mixed metal oxide catalyst suitable for use in the detectors comprise the mixed oxides of a rare earth, barium and copper which have been demonstrated to have superconducting properties at temperatures as high as 90 K. These mixed metal oxides can function as catalysts for redox chemiluminescence monitoring of environments for potential toxic constituents on a continuous or nearly continuous basis.

The redox chemiluminescence detectors may be used in a variety of applications. For example, the detector may act as a continuous alarm when foreign gases reach a threshold concentration indicative of a malfunctional in air cleaning or a catastrophic event such as a fire or spill. Alternatively, the detector could be coupled with a chromatography column used to identify particular constituents. In additional embodiments, the detectors may be used as fire detectors as well as sensors for indicating short term or long term accumulation of toxic compounds in confined spaces or ambient atmospheres.

Various features of the present invention are illustrated in the following examples.

### EXAMPLE 1

Metal complexes were formed from yttrium, barium and copper using a β-diketone ligand comprising 2,2,6,6-tetramethyl-3,5-heptanedione, H(thd). The metal complexes, Y(thd)₃, Ba₂(thd)₄, and Cu(thd)₂ were mixed in the stoichiometric ratio of 1Y:2Ba:3Cu. The mixture was vaporized and the vapors were mixed with air and contacted with a borosilicate glass surface. The borosilicate glass surface was heated to about 500^{o}C. A black thin film formed and upon continued heating in air, a few black crystals began to grow. The black deposit, which consisted of YBa₂Cu₃O₇₋ₓ where x is a number less than 1, did not change color upon continued heating.

### EXAMPLE 2

A borosilicate glass test tube was mounted in a nearly horizontal position on a ring stand. A mixture of Gd(thd)₃, Ba₂(thd)₄ and Cu(thd)₂ was introduced into the tube in the stoichiometric ratio of 1Gd:2Ba:3Cu. The upper portion of the tube was heated to about 500^{o}C while the lower portion of the tube containing the mixed chelates was warmed slowly until the temperature reached about 200^{o}C. As the lower portion of the tube became hotter, vapors of the mixed chelates, visible to the naked eye, wafted into the upper hotter portion of the tube. A black film formed on the upper portion of the tube. Continued heating in contact with air did not change the black color, although the deposit began to glow.

### EXAMPLE 3

A mixture containing tris(1,1,1,2,2,3,3-heptafluoro-7,7-dimethyl-4,6-octanedionato) europium (III), Ba₂(thd)₄ and Cu(tod)₂ was provided in a tube in the stoichiometric ratio of 1Eu:2Ba:3Cu. The mixture was heated at about 500^{o}C for several minutes and a solid deposit was formed. The solid deposit was then treated with elemental fluorine to yield a product containing a fluorine component. The elemental fluorine was generated by passing SF₆ through an electrical discharge.

### EXAMPLE 4

A mixture of 20 mg of Er(thd)₃ (pink crystals), 28 mg of Ba₂(thd)₄ (white powder), and 30 mg of Cu(thd)₂ (purple crystals) was introduced into a borosilicate test tube. The test tube was mounted on a ring stand in a nearly horizontal position. A Meeker burner was placed so as to continuously heat the middle to upper portion of the tube to near 500^{o}C. When the top portion of the tube was heated to just below the softening point of the glass, a hand-held bunsen burner was used to slowly bring the temperature of the lower third of the tube containing the mixed chelates slowly up to the temperature at which they melted to form a dark liquid. As heating was continued, vapors became apparent to the naked eye above the liquid. The temperature of the liquid was then in the range of from 200 to 300^{o}C. Convection of air in the tube carried the mixture of three metal chelates and the oxygen and water vapor present in the ambient air into the middle and upper portion of the test tube maintained near 500^{o}C. As the vapors contacted the hotter borosilicate walls, a thin film of black mixed metal oxides formed in the middle of the tube. In the upper portion of the tube some crystals visible to the naked eye formed. Both the thin film and the crystals glowed with an orange emission. Some fraction of the vapors travelled the length of the tube and were ignited exhibiting a green color characteristic of heated copper and barium by comparison with classical flame tests of copper and barium. Mass spectral measurements of Ba₂(thd)₄ showed that this complex vaporizes at temperatures as low as 150^{o}C. The appearance of the colors in the flame of this example indicates that the desired metals can be mixed in their chelate forms with a fuel and burned in a flame to form the mixed oxide composition. The metals in their chelate forms may alternatively be mixed with hydrogen or nitrogen dioxide to form a vapor mix for burning in a flame or may be dissolved in a fuel such as gasoline or kerosene and nebulized or vaporized for burning, for example, in a flame. These embodiments may be used to form the mixed metal oxide compositions in otherwise difficult to make forms such as particles or powders and under temperature and oxygen stochiometry conditions otherwise difficult or impossible to obtain.

### EXAMPLE 5

The general procedure of Example 4 was repeated using 10 mg of Gd(thd)₃, 14 mg of Ba₂(thd)₄ and 18 mg of Cu(thd)₂. Similar results were obtained including the formation of a black film in the middle of the tube and the formation of crystals in the upper portion of the tube. The color of the vapor-deposited film remained black upon continued heating in air. By contrast, the color of Ba₂(thd)₄ heated alone in air produces white BaO. Gd(thd)₃ heated alone in air produces white Gd₂O₃. Cu(thd)₂ heated alone in air initially produces a shiny metallic copper colored Cu^{o} deposit which gradually forms CuO when more oxygen is added.

### EXAMPLE 6

The general procedures of Example 5 were repeated using a mixture of 10 mg of Yb(thd)₃, 14 mg of Ba₂(thd)₄ and 18 mg of Cu(thd)₂. A black ytterbium, barium, copper oxide film was formed.

### EXAMPLE 7

Mixed metal oxide materials of the formula RBa₂Cu₃O₇₋ₓ where R is a rare earth metal as defined above, for example, the mixed metal oxide materials of Examples 1, 2 and 6, may be used as catalysts, alone or in combination, to facilitate redox reactions such as those which occur in redox chemiluminescence detectors. A preferred material comprises YBa₂Cu₃O₇₋ₓ. The mixed metal oxides in film form as discussed above are particularly suitable. The mixed oxide materials may be substituted for the conventional gold catalyst generally used in the detectors in order to obtain different relative responses for analytes being measured.

The effluent of a chromatography column is mixed with a nitrogen-containing reagent, for example, NO₂ or HNO₃ at about 200 ppm. The mixture is contacted with the heated mixed metal oxide catalyst and the surface of the catalyst becomes more or less oxidized depending on the character and concentration of the compounds which are being measured. If the NO₂ which is added oxidizes either the catalyst's surface or compounds sorbed on the surface, nitric oxide is formed and is detected downstream by chemiluminescence after mixing with ozone. For example, methanol reacts with NO₂ at the surface of RBa₂Cu₃O₇₋ₓ to form nitric oxide, which becomes a surrogate for quantitation of the analyte. When employing the mixed metal oxide catalysts of the present invention, the advantages of altering sensitivity and selectivity of such detectors will be obvious to one of ordinary skill in the art.

## Claims

1. A method for forming a film comprising a mixture of rare earth, alkaline earth and copper oxides on a substrate, comprising the steps of:
(a) forming a metallo-organic complex of each of a rare earth metal, an alkaline earth metal and copper, each of the metallo-organic complexes having a vaporization temperature below the temperatures at which the metallo-organic complexes rapidly thermally decompose, oxidize or hydrolyze;
(b) forming a vaporized mixture of the metallo-organic complexes and contacting the vapors with a substrate on which a film is to be deposited; and
(c) depositing a film comprising a mixture of rare earth, alkaline earth and copper oxides from the vapors onto the substrate wherein said deposition is achieved by a technique selected from
(i) oxidizing the vapors,
(ii) hydrolyzing the vapors at a temperature higher than the respective vaporization temperatures of the metallo-organic complexes,
(iii) irradiating the vapors with radiant energy,
and
(iv) passing the vapors through a plasma.

2. The method as defined by claim 1, wherein the vapors are oxidized with an oxidizing agent selected from the group consisting of oxygen and a mixture of fluorine and oxygen.

3. The method as defined by claim 1, wherein the rare earth metal is selected from the group consisting of yttrium, europium, gadolinium, neodymium, samarium, holmium, erbium and ytterbium.

4. The method as defined by claim 1, wherein the alkaline earth metal is selected from the group consisting of barium and strontium.

5. The method as defined by claim 1, wherein the rare earth metal comprises yttrium and the alkaline earth metal comprises barium.

6. The method as defined by claim 5, wherein the ratio of metallo-organic complexes is controlled to provide a film of the formula RBa₂Cu₃Oₓ where R is a rare earth metal and x is in the range of about 6.5 to about 7.0.

7. The method as defined by claim 1, wherein each metallo-organic complex is formed from an organic complexing agent selected from the group consisting of 2,2,7-trimethyl-3,5-octanedione; 2,2,6,6-tetramethyl-3,5-heptanedione; 1,1,1,2,2,3,3-heptafluoro-7,7-dimethyl-4,6-octanedione; 1,1,1-trifluoro-2,4-pentanedione; 1,1,1,5,5,5-hexafluoro-2,4-pentanedione; and trifluoroacetylcamphor.

8. The method as defined by claim 1, wherein the deposited film is further oxidized by treating the film with an oxidizing agent.

9. The method as defined by claim 8, wherein the oxidizing agent is selected from the group consisting of nitrogen dioxide and ozone.

10. The method as defined by claim 1, wherein the deposited film is treated with elemental fluorine whereby fluorine is introduced into the mixed oxide composition.

11. The method as defined by claim 10, wherein the film is treated with elemental fluorine by passing SF₆ through an electrical discharge and contacting reactive effluent from the discharge chamber with the film.

12. The method as defined by claim 1, wherein the substrate is formed of copper oxide.

13. A film comprising a mixture of rare earth, alkaline earth and copper oxides, obtainable by a process according to claim 1.

## Patentansprüche

1. Verfahren zur Bildung eines Films, umfassend eine Mischung aus Seltenerd-, Erdalkali- und Kupferoxiden auf einem Substrat, das folgende Schritte umfaßt:
(a) Bildung eines metallorganischen Komplexes von jeweils einem Seltenerdmetall, einem Erdalkalimetall und Kupfer, wobei jeder der metallorganischen Komplexe eine Verdampfungstemperatur unter der Temperatur aufweist, bei welcher die metallorganischen Komplexe sich rasch thermisch zersetzen, oxidieren oder hydrolysieren;
(b) Bildung einer verdampften Mischung aus den metallorganischen Komplexen und In-Kontakt-Bringen der Dämpfe mit einem Substrat, auf das ein Film niedergeschlagen werden soll; und
(c) Niederschlagen eines Films, enthaltend eine Mischung aus Seltenerd-, Erdalkali- und Kupferoxiden aus den Dämpfen auf das Substrat, wobei das Niederschlagen durch eine Technik erzielt wird, die ausgewählt wird aus
(i) Oxidieren der Dämpfe,
(ii) Hydrolysieren der Dämpfe bei einer Temperatur, die höher als die entsprechenden Verdampfungstemperaturen der metallorganischen Komplexe ist,
(iii) Bestrahlen der Dämpfe mit Strahlungsenergie,
und
(iv) Hindurchleiten der Dämpfe durch ein Plasma.

2. Verfahren nach Anspruch 1, wobei die Dämpfe mit einem Oxidationsmittel oxidiert werden, ausgewählt aus der Gruppe bestehend aus Sauerstoff und einer Mischung von Fluor und Sauerstoff.

3. Verfahren nach Anspruch 1, wobei das Seltenerdmetall ausgewählt wird aus der Gruppe bestehend aus Yttrium, Europium, Gadolinium, Neodymium, Samarium, Holmium, Erbium und Ytterbium.

4. Verfahren nach Anspruch 1, wobei das Erdalkalimetall ausgewählt wird aus der Gruppe bestehend aus Barium und Strontium.

5. Verfahren nach Anspruch 1, wobei das Seltenerdmetall Yttrium und das Erdalkalimetall Barium umfaßt.

6. Verfahren nach Anspruch 5, wobei das Verhältnis der metallorganischen Komplexe gesteuert wird, um einen Film der Formel RBa₂Cu₃Oₓ zu erhalten, wobei R ein Seltenerdmetall ist und x im Bereich von etwa 6,5 bis etwa 7,0 liegt.

7. Verfahren nach Anspruch 1, wobei jeder metallorganische Komplex aus einem organischen Komplexbildner gebildet wird, ausgewählt aus der Gruppe bestehend aus 2,2,7-Trimethyl-3,5-octandion; 2,2,6,6-Tetramethyl-3,5-heptandion; 1,1,1,2,2,3,3-Heptafluor-7,7-dimethyl-4,6-octandion; 1,1,1-Trifluor-2,4-pentandion; 1,1,1,5,5,5-Hexafluor-2,4,-pentandion; und Trifluoracetylcampher.

8. Verfahren nach Anspruch 1, wobei der niedergeschlagene Film durch Behandlung des Films mit einem Oxidationsmittel weiter oxidiert wird.

9. Verfahren nach Anspruch 8, wobei das Oxidationsmittel ausgewählt wird aus der Gruppe bestehend aus Stickstoffdioxid und Ozon.

10. Verfahren nach Anspruch 1, wobei der niedergeschlagene Film mit elementarem Fluor behandelt wird, wobei Fluor in die gemischte Oxidzusammensetzung eingeleitet wird.

11. Verfahren nach Anspruch 10, wobei der Film mit elementarem Fluor behandelt wird, indem SF₆ durch eine elektrische Entladung hindurchgeleitet und der reaktionsfähige Abfluß von der Entladungskammer mit dem Film in Kontakt gebracht wird.

12. Verfahren nach Anspruch 1, wobei das Substrat aus Kupferoxid gebildet ist.

13. Film, umfassend eine Mischung aus Seltenerd-, Erdalkali- und Kupferoxiden, erhältlich durch ein Verfahren nach Anspruch 1.

## Revendications

1. Procédé de formation d'un film constitué d'un mélange d'oxydes de terre rare, alcalino-terreux et de cuivre sur un substrat, comprenant les étapes suivantes :
(a) la formation d'un complexe métallo-organique de chaque métal de terre rare, de chaque métal alcalino-terreux et de cuivre, chacun des complexes métallo-organiques ayant une température de vaporisation inférieure aux températures auxquelles les complexes métallo-organiques se décomposent, s'oxydent ou s'hydrolysent rapidement sous l'effet de la chaleur ;
(b) la formation d'un mélange vaporisé des complexes métallo-organiques et la mise en contact des vapeurs avec un substrat sur lequel un film doit être déposé ; et
(c) le dépôt d'un film constitué d'un mélange d'oxydes de terre rare, alcalino-terreux et de cuivre à partir des vapeurs sur le substrat, procédé dans lequel ledit dépôt est obtenu par une technique choisie entre :
(i) l'oxydation des vapeurs,
(ii) l'hydrolyse des vapeurs à une température supérieure aux températures de vaporisation respectives des complexes métallo-organiques,
(iii) l'irradiation des vapeurs par une énergie de rayonnement, et
(iv) le passage des vapeurs au travers d'un plasma.

2. Procédé selon la revendication 1, dans lequel les vapeurs sont oxydées à l'aide d'un agent oxydant choisi dans le groupe comprenant l'oxygène et un mélange de fluor et d'oxygène.

3. Procédé selon la revendication 1, dans lequel le métal de terre rare est choisi dans le groupe comprenant l'yttrium, l'europium, le gadolinium, le néodymium, le samarium, l'holmium, l'erbium et l'ytterbium.

4. Procédé selon la revendication 1, dans lequel ledit métal alcalino-terreux est choisi dans le groupe comprenant le baryum et le strontium.

5. Procédé selon la revendication 1, dans lequel le métal de terre rare est constitué d'yttrium et en ce que le métal alcalino-terreux est constitué de baryum.

6. Procédé selon la revendication 5, dans lequel le rapport entre les complexes métallo-organiques est maîtrisé pour fournir un film de formule RBa₂Cu₃Ox où R est un métal de terre rare et x est compris dans la gamme allant d'environ 6,5 à environ 7,0.

7. Procédé selon la revendication 1, dans lequel ledit complexe métallo-organique est formé à partir d'un agent complexant organique choisi dans le groupe comprenant la 2,2,7-triméthyl-3,5-octanedione ; la 2,2,6,6-tétraméthyl-3,5-heptanedione ; la 1,1,1,2,2,3,3-heptafluoro-7,7-diméthyl-4,6-octanedione ; la 1,1,1-trifluoro-2,4-pentanedione ; la 1,1,1,5,5,5-hexafluoro-2,4-pentanedione ; et le trifluoroacétylcamphre.

8. Procédé selon la revendication 1, dans lequel le film déposé est davantage oxydé par traitement du film avec un agent oxydant.

9. Procédé selon la revendication 8, dans lequel l'agent oxydant est choisi dans le groupe comprenant le dioxyde d'azote et l'ozone.

10. Procédé selon la revendication 1, dans lequel le film déposé est traité avec du fluor élémentaire grâce à quoi du fluor est introduit dans la composition d'oxydes mixtes.

11. Procédé selon la revendication 10, dans lequel le film est traité avec du fluor élémentaire en faisant passer du SF₆ au travers d'une décharge électrique et en mettant en contact l'effluent réactif provenant de la chambre à décharge avec le film.

12. Procédé selon la revendication 1, dans lequel le substrat est formé d'oxyde de cuivre.

13. Film comprenant un mélange d'oxydes de terre rare, alcalino-terreux et de cuivre pouvant être obtenu par un procédé selon la revendication 1.
